# EUROPEAN PATENT APPLICATION

(11) **EP 2 983 280 A1**
(43) Date of publication of application: **10.02.2016**
(21) Application number: 14180131.6
(22) Date of filing: 07.08.2014
(51) Int. Cl.: H02M 1/32, G01R 19/165, G01R 31/02, H02H 3/44

(54) **Power conversion device**

(71) Applicant: ABB Technology AG, 8050 Zürich (CH)
(72) Inventor: Steimer, Peter, 5420 Ehrendingen (CH); Buchmann, Beat, 5415 Nussbaumen (CH)
(74) Representative: ABB Patent Attorneys

(57) **Abstract**

The invention relates to a power conversion device, comprising a phase terminal (8), at least one bus terminal (10), at least one branch module (11) arranged in between the phase terminal (8) and the bus terminal (10), and a control module (15), whereby each branch module (11) comprises at least a voltage-source converter valve (1, 2), the branch module (11) further comprises a branch reactor (12) connected in series with the voltage-source converter valve (1, 2) and/or the power conversion device comprises a phase reactor (14) connected in series between the phase terminal (8) and the branch module (11), and the control module (15) is adapted for measuring a branch di/dt (16) over the branch reactor (12) and/or a phase di/dt (17) over the phase reactor (14), generating a turn-off signal if the measured branch di/dt (16) and/or the measured phase di/dt (17) has exceeded a pre-defined threshold value, and, in response to the turn-off signal, turning-off at least one voltage-source converter valve (1, 2).

## Description

### Technical Field

The invention relates to a power conversion device, comprising a phase terminal, at least one bus terminal, at least one branch module arranged in between the phase terminal and the bus terminal, each branch module comprises at least a voltage-source converter valve, and the branch module further comprises a branch reactor connected in series with the voltage-source converter valve and/or the power conversion device comprises a phase reactor connected in series between the phase terminal and the branch module. The invention further relates to a use of said power conversion device and a method for fault protecting a power conversion device against internal and/or external faults.

### Background Art

Recently, high voltage direct current (HVDC) transmission technology based on selfcommutated voltage-source converters (VSC) has become widely used especially in renewable energy transmission together with insulated gate bipolar transistors (IGBT) as most commonly used devices having both turn-on and turn-off capabilities. Generally used are two basic converters types for VSC-HVDC. First, a two-level circuit based on a three-phase bridge with a large number of devices connected in series in each valve and utilising pulse width modulation (PWM), and secondly a modular multi-level converter (MMC). However, MMCs have shown more and more advantages over PWM-based converters, such as low switching losses, easily scalable and almost harmonic-free AC voltage due to generating hundreds of discrete voltage levels with a series of identical modules.

Overcurrent protection for the converter, for example related to short circuits on AC-side, on DC-side and/or related to converter internal short circuits, is an important aspect. The overcurrent protection is typically based on current sensors or on a de-saturation protection in case transistor based semiconductors are used. However, said overcurrent protection measures known from prior art are characterised by disadvantages. For example, the protection is only activated once an overcurrent limit has been exceeded. For a de-saturation protection the situation is not different, as the de-saturation protection only becomes activated once the overcurrent limit has been far exceeded. However, as an overcurrent creates a heavy stress for the semiconductor devices of the converter and is allowed only for a limited number of events, the converter, or a part of the converter, might be already damaged by the overcurrent before the overcurrent is actually detected by before described means known from prior art.

### Summary of invention

Therefore, it is an object of the invention to provide a power conversion device comprising an improved fault protecting capability. It is a further object of the invention that the power conversion device comprises a fast overcurrent detection and respective turn-off capability for protecting the power conversion device.

The object of the invention is solved by the features of the independent claims. Preferred embodiments are detailed in the dependent claims.

Thus, the object of the invention is solved by a power conversion device, comprising a phase terminal, at least one bus terminal, at least one branch module arranged in between the phase terminal and the bus terminal, and a control module, whereby each branch module comprises at least a voltage-source converter valve, the branch module further comprises a branch reactor connected in series with the voltage-source converter valve and/or the power conversion device comprises a phase reactor connected in series between the phase terminal and the branch module, and the control module is adapted for measuring a branch di/dt over the branch reactor and/or a phase di/dt over the phase reactor, generating a turn-off signal if the measured branch di/dt and/or the measured phase di/dt has exceeded a pre-defined threshold value, and, in response to the turn-off signal, turning-off at least one voltage-source converter valve.

It is therefore a key aspect of the invention to provide a di/dt based protection for a cell based converter i.e. comprising a voltage-source converter valve preferably comprising a series of connected cells acting as voltages source. In particular, an overcurrent is detected by means of a di/dt reactor, more particular by the branch di/dt reactor and/or by the phase di/dt reactor, whereby, if the measured branch di/dt respectively the measured phase di/dt has exceeded the pre-defined threshold value indicating the overcurrent, at least one voltage source converter valve, or part of it, is turned off. Therefore, the invention follows a completely different approach known from prior art, where, if an overcurrent was detected, so-called crowd bars have been turned on for taking over the faulty overcurrent, for example, from a DC capacitor. Thus, the solution according to the invention is much simpler without foreseeing capacitors in a DC link of the power conversion device, for example between bus terminals, and requires less equipment by even providing a better overcurrent protection.

Furthermore, as instead of measuring a current I, for example within the branch module, the current over time di/dt is measured, which changes much faster if the (faulty) current increases, the invention provides for a much faster and much more predictive detection of a faulty current, even before the power conversion device reaches its current operational limit. In turn, the invention reduces stress on the power conversion device respectively its power semiconductor devices and increases the lifetime of the power conversion device due to operating the power semiconductor device much longer in a safe operating area (SOA). In other words, compared to prior art solutions, the invention provides for a very efficient and improved fault protecting capability for a power conversion device having an improved and fast turn-off capability in case an overcurrent is detected. In sum, the proposed di/dt based protection comprises a predictive feature such that it is known much earlier that a voltage source converter valve needs to be turned off, before an instantaneous limit is reached, in order to prevent damage of the voltage source converter valve respectively of semiconductors comprised within the voltage source converter valve and/or of the power converter device.

Preferably the power conversion device comprises three phase terminals connected to AC and/or two bus terminals connected to DC. However, it is also possible that the power conversion device comprises a number of m phase terminals and a number of n bus terminals for a m-phase to n-phase power conversion. Preferably, the control module is adapted, in response to the turn-off signal, to turn off all voltage source converter valves of the respective branch module, to turn off a part of the voltage source converter valves of the respective branch module and/or to turn off a part of a respective voltage source converter valve, e.g. some of the semiconductor devices within the respective voltage source converter valve, of the respective branch module.

More preferably, the power conversion device comprises a voltage source phase module, which is adapted to connect to/with two preferably DC bus terminals and one preferably AC phase terminal, whereby the voltage source phase module comprises the branch module, and preferably the phase reactor as well. The voltage source converter valve is preferably provided as defined in norm IEC 62501: 2009, for example comprises a controllable device assembly, which represents a functional unit as part of a voltage source converter phase unit as per norm IEC 62501: 2009 and is characterized by switching actions in response to control signals, for acting like a controllable switch and/or for acting like a controllable voltage source. The branch reactor and/or the phase reactor is preferably provided as inductance. Preferably, the power conversion device is adapted to operate with a nominal current of ≥ 500A, ≥ 1000A, ≥ 5000A, ≥ 10.000A, ≥ 50.000A, ≥ 100.000A, or ≥ 500.000A and/or ≤ 500.000A, ≤ 100.000A, 50.000A, or ≤ 20.000A. An overcurrent is preferably greater than the nominal current, preferably ≥ 1%, ≥ 5%, ≥ 10%, ≥ 20%, ≥ 25% or ≥ 50% greater. The power conversion device is further preferably adapted to operate with and/or voltages of ≥ 1000V, ≥ 5000V, ≥ 10.000V, ≥ 50.000V, ≥ 100.000V, ≥ 500.000V or ≤ 1.000.000V, ≤ 500.000V, ≤ 100.000V, or ≤ 500.000V. The power conversion device is preferably configured as high voltage direct current (HVDC) transmission device. The threshold value could be, exemplary, ≥ 50 A/µs, ≥ 100 A/µ, ≥ 200 A/µs, ≥ 250 A/µs, or 500 A/µs.

It is especially preferred that the branch di/dt is only measured over the branch reactor, but not over the voltage source converter valve. This is advantageous, as the phase reactor usually comprises a limited physical size and a sufficient sensitivity, for example due to a sufficiently big enough inductance, such that the measured branch di/dt is sufficiently accurate for detecting a fault. As a voltage source converter valve is typically much greater in dimension than the branch reactor, for example comprises physically widely distributed cells, a measurement of the current I or the current over time di/dt across the voltage source converter valve is much more inconvenient and in addition much less sensitive compared to a measurement of the current I or the current over time di/dt over the branch reactor only. More preferably, measuring the branch di/dt and/or the phase di/dt comprises receiving a voltage from a change of current over time, and following the equation of di/dt = V / L, whereby L is the respective inductance of the branch reactor and/or the phase reactor.

According to another preferred embodiment the control module is further adapted for checking if at least a part of the voltage-source converter valve is subject to an exception status, and generating the turn-off signal only for the part of the voltage-source converter valve that is not subject to the exception status. Such embodiment is advantageous in case a fast turn-off after detecting a fault, i.e. if the measured branch di/dt and/or the measured phase di/dt has exceeded the predefined threshold value, is not possible due to, for example, an interlocking time of the respective voltage source converter valve. In other words, in case the voltage source converter valve respectively power semi-conductor devices comprised within the voltage source converter valve are subject to turn-off with some delay due to switching restrictions, such exception status could be defined, for example as a delay between an on and off time of the respective source converter valve respectively the power semiconductor devices provided within the voltage source converter valve. Such interlocking time is preferably in the range between ≥ 1 µs and ≤ 50, preferably ≤ 10 µs, for example 40 µs for a 4500 V integrated gate-commutated thyristor as minimum on-time comprised within the voltage source converter valve.

According to another preferred embodiment the power conversion device comprises at least two branch modules each comprising at least one voltage-source converter valve and a branch reactor, whereby the control module is adapted for calculating a sum and/or a difference of the measured branch di/dts of the at least two branch modules, and for generating the turn-off signal if the sum and/or the difference has exceeded the pre-defined threshold value. With such an embodiment, for example, an internal fault within the power conversion device can be detected based on a subtraction of di/dt branch signals of two different branch modules.

According to another preferred embodiment the power conversion device comprises at least two branch modules each comprising at least one voltage-source converter valve and a branch reactor, whereby the branch reactors are coupled together as a coupled branch reactor. By coupling the reactors the complete inductance of the coupled branch reactor is increased such that the individual inductances of the two branch reactors can be decreased. The coupling can be done, for example, via a common air-core and/or iron-core. Thus, such embodiment is very space-efficient.

According to another preferred embodiment the voltage-source converter valve comprises at least an unipolar or bipolar power cell or a plurality of unipolar and/or bipolar power cells connected in series, whereby each unipolar and/or bipolar power cell comprises at least two power semiconductor devices connected in series and each comprising two main contacts, a separate free-wheeling diode being connected in parallel to the two main contacts of each power semiconductor device in an opposite direction, and an energy storage device, serving as power cell capacitor, connected in parallel to the series of power semiconductor devices and two power cell connecting terminals connected in parallel to the two main contacts of one of the least two power semiconductor devices or connected in parallel to each two interconnected main contacts for bipolar power cell. According to another preferred embodiment the voltage-source converter valve comprises an integrated gate-commutated thyristor device (IGCT), an insulated-gate bipolar transistor device (IGBT) and/or a silcon carbide based unipolar or bipolar device as power semiconductor device. In addition to that, any other suitable power semiconductor device could be used as well. More preferably, the integrated gate-commutated thyristor device, the insulated-gate bipolar transistor device and/or a silcon carbide based unipolar or bipolar device is provided as bi-mode variant with integrated reverse-conducting diode as free-wheeling diode on wafer-level. Exemplary, the IGBT is provided as a bi-mode insulated-gate bipolar transistor device (BIGT), whereby the BIGT and the reverse-conducting diode utilize the same silicon volume in both operational modes.

According to another preferred embodiment the branch reactor and/or the phase reactor is provided as an air-core and/or iron-core inductor. Thus, the branch reactor and/or the phase reactor preferably comprises an inductor not using a magnetic core made of a ferromagnetic material, instead comprising a coil wound, for example, on plastic, ceramic, or other nonmagnetic forms, or only air inside windings of the inductance. Air core coils have lower inductance than ferromagnetic core coils. In case of an iron-core inductor the reactor preferably comprises a magnetic core made of a ferromagnetic or ferrimagnetic material such as iron or ferrite to increase the inductance.

According to another preferred embodiment the power conversion device comprises a voltage measuring device adapted for measuring the branch di/dt over the branch reactor and/or the phase di/dt over the phase reactor. Preferably the voltage measuring device is adapted for measuring the voltage of each branch reactor and/or phase reactor present in the power conversion device. Further preferred the voltage measuring device, and/or the control module, is configured for measuring the voltage across the respective branch reactor and/or phase reactor preferably between two terminals or connectors directing contacting respectively surrounding the respective branch reactor and/or phase reactor. More preferably the voltage measuring device is integrated as a single unit with the control module.

The object of the invention is further solved by a use of the power conversion device as described before in a pumped hydro storage device, in a rolling mills device, in a compressor and pump device, in a static synchronous compensator device, in a battery energy storage device and/or in a high-voltage direct current device. The object of the invention is furthermore solved by a pumped hydro storage device, rolling mills device, compressor and pump device, static synchronous compensator device, battery energy storage device and/or high-voltage direct current device comprising the power conversion device as described before.

The pumped hydro storage device is preferably provided as a hydroelectric energy storage device used for load balancing of an electric power system, and comprises in particular means for pumping water from a lower elevation reservoir to a higher elevation, and means for releasing stored water through turbines to produce electric power. The rolling mills device preferably comprises means for rolling a work piece such as, for example, metal. The static synchronous compensator device is preferably provided as a static synchronous compensator (STATCOM), also known as a "static synchronous condenser", i.e. as a regulating device used on alternating current electricity transmission networks and more preferably it is based on a power electronics voltage-source converter for acting either as a source or as a sink of a reactive AC power to an electricity network. The battery energy storage device preferably comprises a device for storing energy, for example an accumulator.

The object of the invention is even furthermore solved by a method for fault protecting a power conversion device against internal and/or external faults, the power conversion device comprising a phase terminal and least one bus terminal, and a branch module arranged in between phase terminal and each bus terminal, each branch module comprises at least a voltage-source converter valve, and the branch module further comprises a branch reactor connected in series with the voltage-source converter valve and/or comprising a phase reactor connected in series between the phase terminal and the branch module, whereby the method comprises the steps of measuring a branch di/dt over the branch reactor and/or a phase di/dt over the phase reactor, generating a turn-off signal if the measured branch di/dt and/or if the measured phase di/dt has exceeded a pre-defined threshold value, and turning off the at least one voltage-source converter valve in response to the turn-off signal.

Such method allows for very sensitively and early detecting an internal and/or external faults of the power conversion device, for example due to an overcurrent, and, in case the fault is detected i.e. if the pre-defined threshold value is exceeded, turning off at least a part of the power conversion device i.e. a at least one voltage-source converter valve or a part of the at least one voltage-source converter valve.

According to another preferred embodiment the method comprises the further step of checking if at least a part of the voltage-source converter valve is subject to an exception status, and generating the turn-off signal only for the part of the voltage-source converter valve that is not subject to the exception status. Such exception status might relate due to an interlocking time of a respective voltage-source converter valve or a part of the respective voltage-source converter valve, for example, a power semiconductor device. The exception status may last a defined time period and could be cleared automatically after the defined time period is over. Thus, it might be possible that the turn-off signal is generated with some delay, for example with a delay of ≥ 1 µs and/or ≤ 50 µs, after the pre-defined threshold value has been exceeded.

According to another preferred embodiment the method comprises at least two branch modules each comprising at least a voltage-source converter valve and a branch reactor, the step of calculating a sum and/or a difference of the measured branch di/dts of the at least two branch modules, and generating the turn-off signal if the sum and/or the difference has exceeded the pre-defined threshold value. Such an embodiment allows for differentiating if the fault is a power conversion device internal fault, for example within a voltage-source converter valve, or an external fault, for example of a connected AC network.

Further embodiments of the method are directly and unambiguously apparent for the man skilled in the art from before described power conversion device.

### Brief description of drawings

These and other aspects of the invention will be apparent from and elucidated with reference to the embodiments described hereinafter.

In the drawings:
Fig. 1a shows a voltage-source converter valve provided with a bipolar power cell according to a preferred embodiment of the invention,
Fig. 1b shows another voltage-source converter valve provided with an unipolar power cell according to another preferred embodiment of the invention,
Fig. 2 shows a power conversion device with plurality of voltage-source converter valve according to Fig. 1b,
Fig. 3 shows a power conversion device according to another preferred embodiment of the invention,
Fig. 4 shows a power conversion device according to yet another preferred embodiment of the invention, and
Fig. 5 shows a detail of the power conversion device according to Fig. 2.

### Description of embodiments

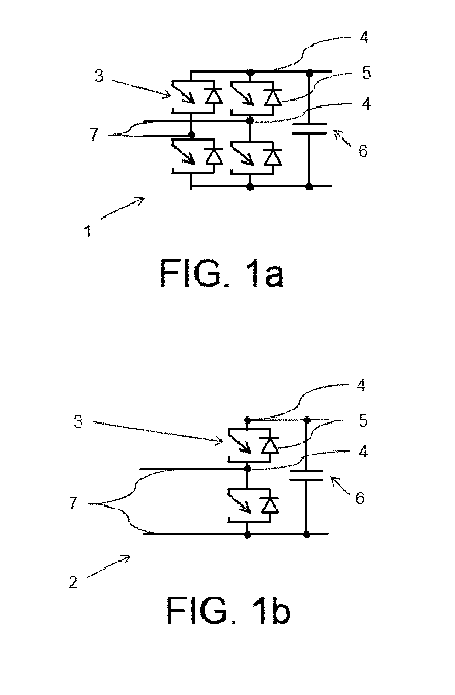

Fig. 1a shows voltage-source converter valve 1 provided with a bipolar power cell according to a preferred embodiment of the invention and Fig. 1b shows another voltage-source converter valve 2 provided with an unipolar power cell according to another preferred embodiment of the invention. The voltage-source converter valve 1 provided with the bipolar power cell comprises four power semiconductor devices 3 connected each two in series and the two series in parallel. The voltage-source converter valve 2 provided with the unipolar power cell comprises two power semiconductor devices 3 connected in series. Each power semiconductor device 3 is provided as an insulated-gate bipolar transistor (IGBT)-device, while it is also possible to use an integrated gate-commutated thyristor (IGCT)-device or a silicon-carbide (SiC) based unipolar or bipolar devices.

Each power semiconductor device 3 further comprises two main contacts 4 and a free-wheeling diode 5 connected in parallel to the two main contacts 4 of each power semiconductor device 3 in an opposite direction. In particular, the power semiconductor device 3 provided as integrated gate-commutated thyristor (IGCT) device may be provided as a bi-mode variant of an IGBT, IGCT or SiC based device with an integrated reverse-conducting diode on wafer-level as free-wheeling diode 5. Further, an energy storage device 6, serving as power cell capacitor, is connected in parallel to the series of power semiconductor devices 3. The voltage-source converter valve 2 provided with the unipolar power cell furthermore comprises two power cell connecting terminals 7 connected in parallel to the two main contacts 4 of one of the least two power semiconductor devices 3, as apparent from Fig. 1 b. The power cell connecting terminals 7 of the voltage-source converter valve 1 provided with bipolar power cell are connected each to two interconnected main contacts 4 of the power semiconductor devices 3 connected in series, as apparent from Fig. 1 a.

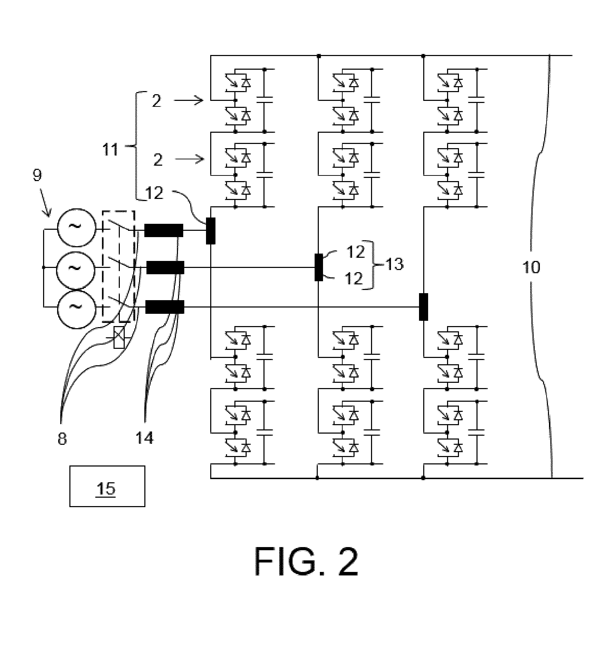

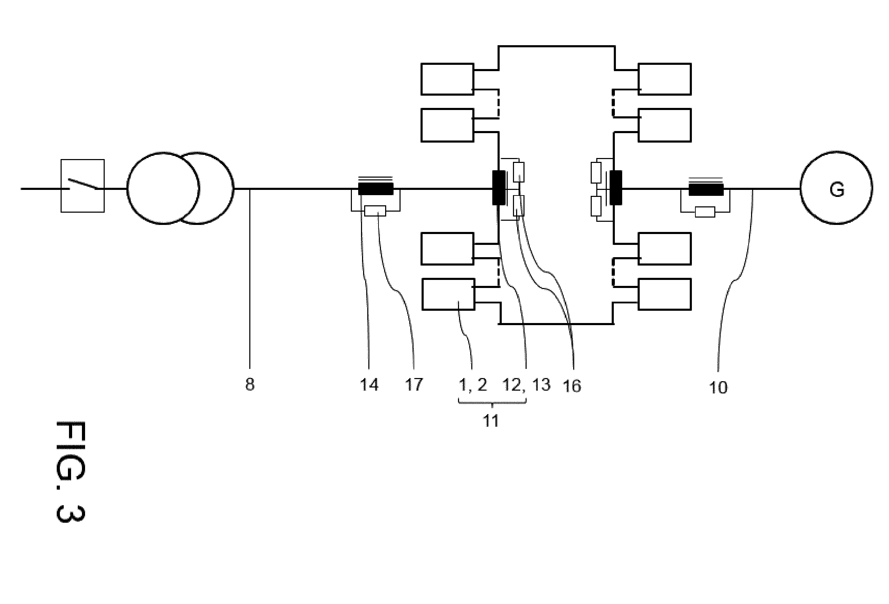

Fig. 2 shows a power conversion device according to a preferred embodiment of the invention comprising a plurality of voltage-source converter valves 2 provided with the unipolar power cells. In particular, the power conversion device according to Fig. 2 comprises three phase terminals 8 connected via a switch to a three phase AC source 9, two bus terminals 10 and six branch modules 11 connected each one to one of the three phase terminals 8 and to one of the bus terminal 10. Each branch module 11 comprises two voltage-source converter valves 2, which, according to Fig. 2, are provided with unipolar power cells and are connected in series with their respective power cell connecting terminals 7. It is also possible that the voltage-source converter valves 1 comprise bipolar cells, as depicted in the more schematic view in Fig. 3.

Each branch module 11 further comprises a branch reactor 12 provided as an inductance connected in series with the voltage-source converter valves 2 such that, starting from the phase terminal 8, the branch reactor 12 is arranged first and followed by the two voltage-source converter valves 2 connected in series. Each two branch reactors 12 of two associated branch modules 11 connected to the same phase terminal 8 and different bus terminals 10 are provided as a coupled branch reactor 13 i.e. as a coupled, single inductance for two branch modules 11 that is connected to the same phase terminal 8 and to two different bus terminals 10, whereby the inductance of the coupled branch reactor 13 is equally shared between the two branch modules 11. The power conversion device further comprises three phase reactors 14 provided as inductance and each connected between/with one the three phase terminals 8 and each two of the six branch modules 11 i.e. each between a phase terminal 8 and a coupled branch reactor 13.

The power conversion device furthermore comprises a control module 15, which is adapted for measuring a branch di/dt 16, see Fig. 3, over each of the branch reactors 12 respectively over the coupled branch reactor 13 for detecting an internal short circuit of the power conversion device, as well as for measuring a phase di/dt 17 over each of the phase reactors 14 for detecting an external short circuit. In case the measured branch di/dt 16 or the measured phase di/dt 17 has exceeded a pre-defined threshold value, the control module 15 generates a turn-off signal such that, in response to the turn-off signal, at least one of the voltage-source converter valves 1, 2 respectively at least one power semiconductor devices 3 within the voltage-source converter valves 1, 2 is turned off. However, the branch di/dt 16 is not measured over the typically lengthy series of voltage-source converter valves 1, 2, but only over the respective branch reactor 12, which makes the measurement very easy.

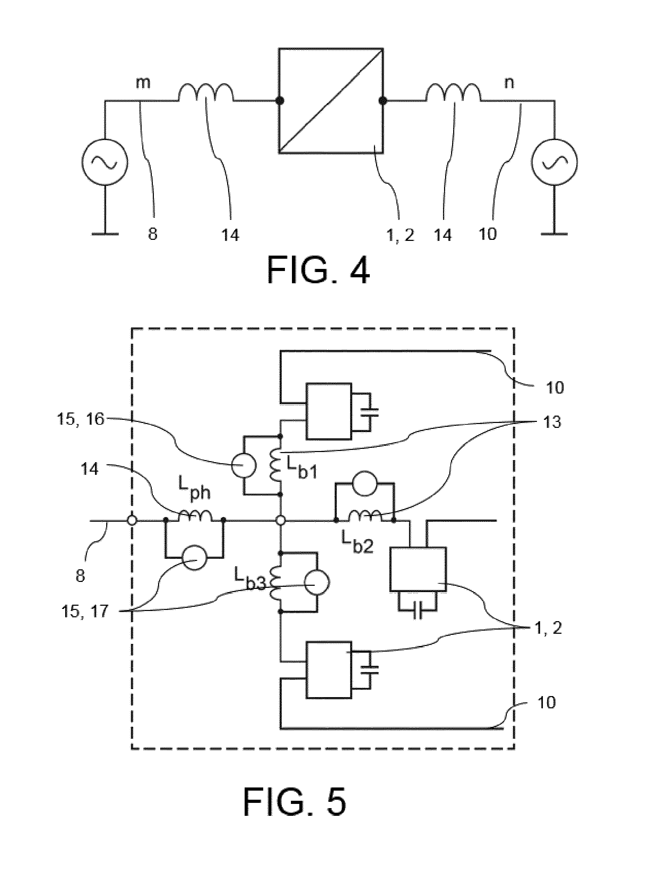

Within the embodiment shown in Fig. 3 for one phase, each two branch modules 11 are connected in series such that on both "ends" the respective branch reactors 12 are couple together as, in total, two coupled branch reactors 13, which are then, each, connected via a phase reactor 14 to a phase terminal 8 respectively a terminal 10. Such an embodiment for converting m-phases to n-phases is shown in an even more high-level view in Fig. 4. Between the phase terminal 8 and the terminal 10, connected each via a phase reactor 14, there is at least one branch module 11, depicted as "black box" connected.

Fig. 5 shows a detailed view of Fig. 2 with only one phase terminal 8 and three terminals 10, each being connected via a voltage-source converter valve 1, 2 and a respective branch reactor 13, labelled as "L_{b1}, L_{b2}, L_{b3}", in a star-shaped manner together with the phase terminal 8 being connected to the star via the phase reactor 14, labelled as "Lₚₕ". The control module 15 is arranged for measuring all three branch di/dts 16 over the three "L_{b1}, L_{b2}, L_{b3}" branch reactors 13 and the phase di/dt 17 over the "Lₚₕ" phase reactor 14.

In particular, the measurement of the branch di/dt 16 respectively of the phase di/dt 17 is carried out with the control module 15 by measuring the voltage over the branch reactor 13 respectively the phase reactor 14, as voltage equals the inductance L of the respective reactor 13, 14 multiplied by di/dt (V = L x di/dt). Thus, external faults or AC faults, e.g. with the phase terminals 8 or the AC source 9, can be detected based on a phase di/dt 17 signal of the phase reactor 14 i.e. on an AC reactor 14. It is also possible to detect external or AC faults based for example on a sum of branch di/dt 16 signals of two different branch reactors 14 of different branch modules 11 i.e. by a combination of different signals. It is furthermore possible to detect internal faults based for example on a subtraction of branch di/dt 16 signals of different branch reactors14 of different branch modules 11 i.e. by a combination of different signals.

The control module 15 is further adapted for checking if at least a part of the voltage-source converter valve 1, 2 is subject to an exception status, and generating the turn-off signal only for the part of the voltage-source converter valve 1, 2 that is not subject to the exception status. This means that the control module 15 checks if, for example, an eventual interlocking time as exception status prevents shutting down at least one of the voltage-source converter valves 1, 2, especially if enough blocking voltage is available by using available, non-faulty voltage-source converter valves 1, 2 cells respectively power semiconductor devices 3 only. Such exception status may include a clearance duration of, for example, a range between ≥ 1 µs and ≤ 50 µs, for example 40 µs for a 4500 V integrated gate-commutated thyristor as power semiconductor device 3, such that, after the clearance duration as waiting time is over, the in response to the turn-off signal, the at least one of the voltage-source converter valves 1, 2 respectively at least one power semiconductor devices 3 within the voltage-source converter valves 1, 2 is turned off.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 1: voltage-source converter valve provided with a bipolar power cell
- 2: voltage-source converter valve provided with a unipolar power cell
- 3: power semiconductor device
- 4: main contact
- 5: free-wheeling diode
- 6: energy storage device
- 7: power cell connecting terminal
- 8: phase terminal
- 9: AC source
- 10: bus terminal
- 11: branch module
- 12: branch reactor
- 13: coupled branch reactor
- 14: phase reactor
- 15: control module
- 16: branch di/dt
- 17: phase di/dt

## Claims

1. Power conversion device, comprising a phase terminal (8), at least one bus terminal (10), at least one branch module (11) arranged in between the phase terminal (8) and the bus terminal (10), and a control module (15), whereby
each branch module (11) comprises at least a voltage-source converter valve (1, 2),
the branch module (11) further comprises a branch reactor (12) connected in series with the voltage-source converter valve (1, 2) and/or the power conversion device comprises a phase reactor (14) connected in series between the phase terminal (8) and the branch module (11), and
the control module (15) is adapted for measuring a branch di/dt (16) over the branch reactor (12) and/or a phase di/dt (17) over the phase reactor (14), generating a turn-off signal if the measured branch di/dt (16) and/or the measured phase di/dt (17) has exceeded a pre-defined threshold value, and, in response to the turn-off signal, turning-off at least one voltage-source converter valve (1, 2).

2. Power conversion device according to the previous claim, whereby the control module (15) is further adapted for checking if at least a part of the voltage-source converter valve (1, 2) is subject to an exception status, and generating the turn-off signal only for the part of the voltage-source converter valve (1, 2) that is not subject to the exception status.

3. Power conversion device according to any of the previous claims, comprising at least two branch modules (11) each comprising at least one voltage-source converter valve (1, 2) and a branch reactor (12), whereby the control module (15) is adapted for calculating a sum and/or a difference of the measured branch di/dts (16) of the at least two branch modules (11), and for generating the turn-off signal if the sum and/or the difference has exceeded the pre-defined threshold value.

4. Power conversion device according to any of the previous claims, comprising at least two branch modules (11) each comprising at least one voltage-source converter valve (1, 2) and a branch reactor (12), whereby the branch reactors (12) are coupled together as a coupled branch reactor (13).

5. Power conversion device according to any of the previous claims, whereby the voltage-source converter valve (1, 2) comprises
at least an unipolar power cell (2) or bipolar power cell (1) or a plurality of unipolar power cells (2) and/or bipolar power cells (1) connected in series, whereby each unipolar power cell (2) and/or bipolar power cell (1) comprises
at least two power semiconductor devices (3) connected in series and each comprising two main contacts (4),
a separate free-wheeling diode ( 5) being connected in parallel to the two main contacts (4) of each power semiconductor device (3) in an opposite direction, and
an energy storage device (6), serving as power cell capacitor, connected in parallel to the series of power semiconductor devices (3) and
two power cell connecting terminals (7) connected in parallel to the two main contacts (4) of one of the least two power semiconductor devices (3) for the unipolar power cell (2) or connected in parallel to each two interconnected main contacts (4) for bipolar power cell (1).

6. Power conversion device according to any of the previous claims, whereby the voltage-source converter valve (1, 2) comprises an integrated gate-commutated thyristor device, an insulated-gate bipolar transistor device and/or a silcon carbide based unipolar or bipolar device.

7. Power conversion device according to the previous claim, whereby the integrated gate-commutated thyristor device and/or the insulated-gate bipolar transistor device and/or the silcon carbide based unipolar or bipolar device is provided as a bi-mode variant with an integrated reverse-conducting diode as free-wheeling diode ( 5) on wafer-level.

8. Power conversion device according to any of the previous claims, whereby the branch reactor (12) and/or the phase reactor (14) is provided as an air-core and/or iron-core inductor.

9. Power conversion device according to any of the previous claims, comprising a voltage measuring device (15) adapted for measuring the branch di/dt (16) over the branch reactor (12) and/or the phase di/dt (17) over the phase reactor (14).

10. Use of a power conversion device according to any of the previous claims in a pumped hydro storage device, in a rolling mills device, in a compressor and pump device, in a static synchronous compensator device, in a battery energy storage device and/or in a high-voltage direct current device.

11. Pumped hydro storage device rolling mills device, compressor and pump device, static synchronous compensator device, battery energy storage device and/or high-voltage direct current device comprising the power conversion device according to any of the previous device claims.

12. Method for fault protecting a power conversion device against internal and/or external faults, the power conversion device comprising a phase terminal (8) and least one bus terminal (10), and a branch module (11) arranged in between a phase terminal (8) and each bus terminal (10),
each branch module (11) comprises at least a voltage-source converter valve (1, 2), and
the branch module (11) further comprises a branch reactor (12) connected in series with the voltage-source converter valve (1, 2) and/or comprising a phase reactor (14) connected in series between the phase terminal (8) and the branch module (11), whereby the method comprises the steps of
measuring a branch di/dt (16) over the branch reactor (12) and/or a phase di/dt (17) over the phase reactor (14),
generating a turn-off signal if the measured branch di/dt (16) and/or if the measured phase di/dt (17) has exceeded a pre-defined threshold value, and
turning off the at least one voltage-source converter valve (1, 2) in response to the turn-off signal.

13. Method according to the previous method claim, comprising the further step of
checking if at least a part of the voltage-source converter valve (1, 2) is subject to an exception status, and
generating the turn-off signal only for the part of the voltage-source converter valve (1, 2) that is not subject to the exception status.

14. Method according to any of the previous method claims, comprising at least two branch modules (11) each comprising at least a voltage-source converter valve (1, 2) and a branch reactor (12), the method comprising the step of
calculating a sum and/or a difference of the measured branch di/dts (16) of the at least two branch modules (11), and
generating the turn-off signal if the sum and/or the difference has exceeded the pre-defined threshold value.
